# EUROPEAN PATENT APPLICATION

(11) **EP 4 621 841 A1**
(43) Date of publication of application: **24.09.2025**
(21) Application number: 24165515.8
(22) Date of filing: 22.03.2024
(51) Int. Cl.: H01L 23/00, H01L 23/538

(54) **METHOD FOR FORMING INTERCONNECT LAYER**

(71) Applicant: Imec VZW, 3001 Leuven (BE)
(72) Inventor: GOLSHANI, Negin, 3300 Tienen (NL); VERHEYEN, Peter, 2560 Nijlen (BE); VAN CAMPENHOUT, Joris, 3001 Leuven (BE)
(74) Representative: Winger

(57) **Abstract**

The invention relates to a method for forming electrical connections in devices with a top surface featuring an electrical path and a cavity for a die. It involves creating a continuous interconnect layer from the cavity's bottom to the electrical path, overcoming topographical hurdles. It also relates to a corresponding device.

## Description

### Field of the Invention

The present invention pertains to the field of semiconductor device fabrication, specifically to methods and structures for forming interconnects.

### Background of the Invention

The field of electrical and electro-optical testing in high aspect ratio structures, particularly those containing stacked die, is a complex and evolving area of technology. As electronic devices become increasingly miniaturized and complex, the need for efficient and reliable interconnection methods grows. The integration of multiple dies within a single package, often referred to as 3D packaging, presents unique challenges for testing and interconnection.

Accessing and testing the electrical connections of dies within cavities of electronic or opto-electronic devices presents significant challenges.

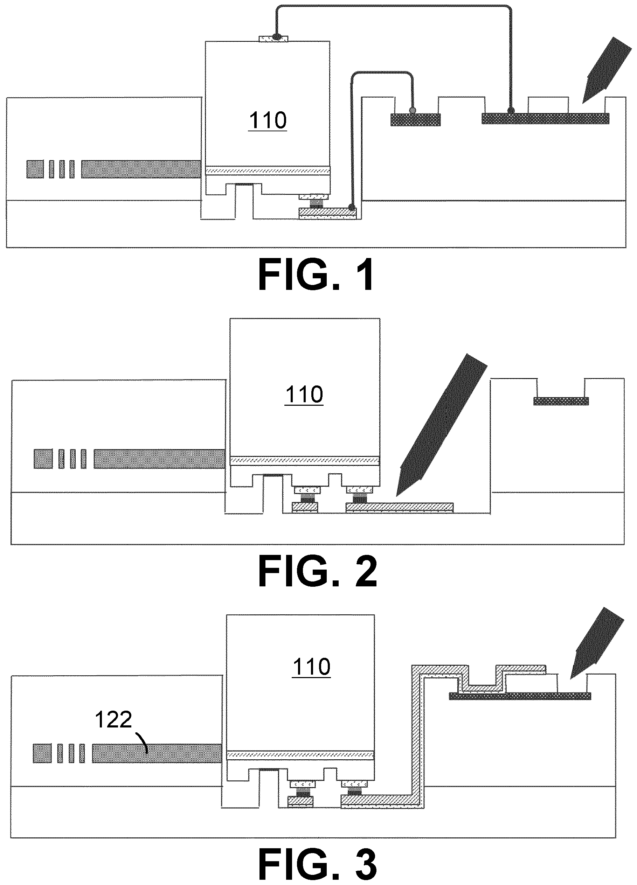

Traditional methods to form these electrical connections, such as wire bonding (see Fig. 1), have limitations. The common use of copper (Cu) for forming electrical connections, favored for its low electrical resistivity, is susceptible to oxidation during the wire bonding process, potentially compromising the electrical connection integrity. The bonding process further complicates matters when tin (Sn) is used, as melting Sn can lead to it squeezing out and inadvertently forming connections with the copper in the electrical connection, raising the risk of short circuits or other failures. Accurately measuring the bonded device becomes a daunting task owing to the complex internal structure and the constrained space available for testing probes or measurement instruments. Hence, these methods typically necessitate a large cavity (see Fig. 2) within the structure to facilitate the bonding process and ensure pad accessibility, which introduces several technical complexities. Additionally, the requirement for wire bonding or creating a significantly large cavity not only complicates and escalates the cost of the manufacturing process but also heightens the risk of inflicting damage to the delicate internal components during the bonding and testing phases.

These challenges highlight the need for improved methods for forming electric connections that can accommodate the intricate designs of modern electronic devices. The industry continues to seek advancements that can streamline the manufacturing process, enhance the reliability of the connections, and facilitate easier testing of the final product. Despite the progress made in recent years, there is still a need for further advancements in the field to address these challenges effectively.

### Summary of the Invention

It is an object of embodiments of the present invention to facilitate the formation and testing of electrical connections in electro-optic or electronic devices. This objective is accomplished by a method for forming electrical connections in an electro-optic or electronic device according to the invention.

In the first aspect, the present invention relates to a method for forming electrical connections in an electro-optic or electronic device comprising a top surface exposing an electrical path, and a cavity in the top surface, said cavity being for housing a die, said electrical connections being suitable for connecting the electrical path and the die, wherein forming the electrical connections comprises forming a continuous interconnect layer extending from a bottom of the cavity, across any topographical features, to the electrical path.

In embodiments, the continuous interconnect layer may include an electrically conductive protection layer suitable to prevent disconnection in the continuous interconnect layer during a wet etch process. This embodiment provides the advantage of maintaining the integrity of the interconnect layer during processing.

In embodiments, the electrically conductive protection layer may comprise a metal with wet etching selectivity to the conductive material used to form the continuous interconnect layer. For instance, if this conductive material is copper, the electrically conductive protection layer may comprise a metal with wet etching selectivity to copper. This embodiment offers the advantage of selective etching, which preserves the integrity of the continuous interconnect layer.

In embodiments where the continuous interconnect layer is made of copper, the metal may be selected from nickel and cobalt. The advantage of this embodiment is the use of metals that provide effective protection with good etching selectivity to copper.

In embodiments, the protection layer may have a thickness of from 0.1 to 3.0 µm, preferably from 0.2 to 2.0 µm, more preferably from 0.3 to 1.0 µm, yet more preferably from 0.3 to 0.7 µm. This embodiment ensures adequate protection without significantly impacting the overall conductivity of the interconnect layer.

In embodiments, the method may further comprise the step of depositing a seed layer on the device prior to forming the continuous interconnect layer, and comprising the step of etching the seed layer after the forming of the electrical connections so as to leave the seed layer under the electrical connections but remove it everywhere else. This embodiment allows for precise control of where the interconnect layer is formed. When this embodiment is used, it is particularly advantageous to use a protection layer to preserve better the electrical connections during the removal of the seed layer.

In embodiments, the method may further comprise depositing a barrier layer on the device before depositing the seed layer, and wherein the step of etching the seed layer is followed by a step of etching the barrier layer so as to leave the barrier layer under the electrical connections but remove it everywhere else. This embodiment provides the advantage of preventing unwanted diffusion between the interconnect layer and underlying materials.

In embodiments, the barrier layer may be configured to prevent diffusion between the continuous interconnect layer and underlying materials. The advantage of this embodiment is the prevention of material intermixing that could degrade device performance.

In embodiments, the barrier layer may be made of TiW, TiN, or TaN. This embodiment offers the advantage of using materials known for their effective barrier properties.

In embodiments, the method may further comprise the step of forming connection bumps for the die on the continuous interconnect layer on the bottom of the cavity. This embodiment provides the advantage of facilitating reliable electrical connections between the die and the interconnect layer.

In embodiments, the method may further comprise the step of etching the seed layer, and if present the barrier layer, after the formation of the connection bumps. This embodiment allows for a single seed layer etch, improving process efficiency.

In embodiments, forming the connection bumps may comprise forming a patterned mask having openings exposing the continuous interconnect layer only where the connection bumps will be formed, followed by electroplating a metal through said openings. This embodiment provides the advantage of precise bump placement and size control.

In embodiments, the material of the connection bumps may comprise at least one of tin, silver, bismuth, indium, copper, cobalt, and gold. This embodiment offers the advantage of selecting bump materials that are suitable for various bonding temperatures and mechanical properties.

In embodiments, the electrical path may be configured to enable electrical or electro-optical tests of the die. This embodiment provides the advantage of facilitating testing of the die without the need for additional connections.

In embodiments, the method may comprise using a lift-off process for forming the continuous interconnect layer, wherein the lift-off process involves depositing the continuous interconnect layer material on a patterned resist and then removing the resist to leave the continuous interconnect layer only in desired locations, i.e., where the resist was not present. This embodiment offers the advantage of a potentially simpler process for forming the interconnect layer.

In embodiments, the top surface may comprise therein a number of cavities for housing a die, said number of cavities forming a pattern, wherein the method further comprises providing a carrier substrate removably attached to a same number of dies arranged in this same pattern, physically contacting the dies, attached to the carrier substrate, with the electronic device in such a way that each die is housed in a cavity and connects electrically with the continuous interconnect layer present at the bottom of the cavity, and detaching the carrier substrate from the dies. This embodiment provides the advantage of efficient die placement and bonding in a patterned array.

In embodiments, the cavity may suitable for laterally housing a die. In embodiments, the width of the cavity may at most be 40% larger than the width of the die. For instance, the width of the cavity can be from 5 µm to 1000 µm, such as from 50 to 950 µm, from 100 to 900 µm, or from 200 to 850 µm. In embodiments, the length of the cavity may be from 10 µm to 5.0 mm, such as from 100 µm to 4.5 mm, from 200 µm to 4.0 mm, or from 400 µm to 3.5 mm. In embodiments, the height of the cavity may be from 20 to 100 µm.

Any element of the first aspect may be as correspondingly described in the second aspect.

In the second aspect, the present invention relates to an electro-optic or electronic device comprising a top surface exposing an electrical path, a cavity in the top surface for housing a die, and a continuous interconnect layer extending from a bottom of the cavity, across any topographical features, to the electrical path.

In embodiments, the continuous interconnect layer may include a protection layer comprising a metal with wet etching selectivity to the material making the continuous interconnect layer, e.g. copper. This embodiment provides the advantage of protecting the interconnect layer during processing.

In embodiments, the material making the continuous interconnect layer may be copper and the metal may be nickel or cobalt. The advantage of this embodiment is the use of metals that provide effective protection with good etching selectivity.

In embodiments, the protection layer may have a thickness of from 0.1 to 3.0 µm, preferably from 0.2 to 2.0 µm, more preferably from 0.3 to 1.0 µm, yet more preferably from 0.3 to 0.7 µm. This embodiment ensures adequate protection without significantly impacting the overall conductivity of the interconnect layer.

In embodiments, the device may further comprise a barrier layer between the continuous interconnect layer and underlying materials. This embodiment provides the advantage of preventing unwanted diffusion between the interconnect layer and underlying materials.

In embodiments, the barrier layer may comprise or consist of TiW, TiN, or TaN. This embodiment offers the advantage of using materials known for their effective barrier properties.

In embodiments, the device may further comprise connection bumps for the die on the continuous interconnect layer on the bottom of the cavity. This embodiment provides the advantage of creating reliable electrical connections between the die and the interconnect layer.

In embodiments, the material of the connection bumps may comprise at least one of tin, silver, bismuth, indium, copper, cobalt, and gold. This embodiment offers the advantage of selecting bump materials that are suitable for various bonding temperatures and mechanical properties.

In embodiments, the electrical path may be configured to enable electrical or electro-optical tests of the die. These electrical or electro-optical tests are typically tests of the embedded die and are performed from the top surface. This embodiment provides the advantage of facilitating testing of the die without the need for additional connections.

Any element of the second aspect may be as correspondingly described in the first aspect.

It is an advantage of embodiments of the present invention that it facilitates the connection between a housed die and the electrical path without the need for wire bonding or large cavities. It is a further advantage of embodiments of the present invention that the continuous interconnect layer can include an electrically conductive protection layer, such as nickel or cobalt, which is suitable to prevent disconnection during a wet etch process, thus enhancing the reliability of the electrical connections. It is yet another advantage of embodiments of the present invention that the protection layer can be applied with a thickness that does not significantly impact the overall resistance of the interconnect layer, thereby maintaining the electrical performance while providing protection.

Moreover, it is an advantage of embodiments of the present invention that the electrical path may be configured to enable electrical or electro-optical tests of the die from the top surface, simplifying the testing process and eliminating the need for large cavities or complex wire bonding procedures.

Furthermore, it is an advantage of embodiments of the present invention that a carrier substrate can be used to facilitate the alignment and attachment of a plurality of dies to the device, with the dies arranged in a pattern that corresponds to a pattern of cavities on the device, thereby streamlining the assembly process for devices with multiple dies.

In summary, it is an advantage of embodiments of the present invention that the described method and device offer a streamlined, reliable, and efficient approach to forming electrical connections in electro-optic or electronic devices, which can significantly improve the manufacturing process and the performance of the resulting devices.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 is a cross-sectional view of a prior art device showing wire connections for testing on the top surface.
Fig. 2 is a cross-sectional view of a prior art device showing direct testing in a large cavity housing the die.
Fig. 3 is a cross-sectional view of an embodiment of the invention with testing accessible from the top surface electrical connections.
Fig. 4 is a side view of the invention showing multiple cavities prepared for die attachment, and dies being lowered therein.
Fig. 5 is a sequence of side views of the invention demonstrating the alignment and attachment process of dies on a patterned substrate to the device's cavities, including the detachment of the substrate.
Fig. 6 is a cross-sectional view of a first embodiment of the invention without an electrically conductive protection layer, highlighting the disadvantages.
Fig. 7 is a cross-sectional view of another embodiment of the invention with an electrically conductive protection layer, illustrating the advantages.
Fig. 8 depicts a scanning microscope image of an electrical connection in a semiconductor device according to an embodiment of the present invention. A defective part of the electrical connection is shown.
Fig. 9 depicts a scanning microscope image of an electrical connection in a semiconductor device according to another embodiment of the present invention, where a protective coating is used on top of the continuous interconnect layer.

In the different figures, the same reference signs refer to the same or analogous elements.

### Detailed description of Illustrative Embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top and over and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", also used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be interpreted as being limited to devices consisting only of components A and B. It means that with respect to the present invention, the only relevant components of the device are A and B. The term "comprising" therefore covers the situation where only the stated features are present and the situation where these features and one or more other features are present. The word "comprising" according to the invention therefore also includes as one embodiment that no further components are present. When the word "comprising" is used to describe an embodiment in this application, it is to be understood that an alternative version of the same embodiment, wherein the term "comprising" is replaced by "consisting of", is also encompassed within the scope of the present invention.

Similarly, it is to be noticed that the term "coupled" should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

As used herein, and unless otherwise specified, the term "electrical connections" refers to conductive pathways or structures comprising a continuous interconnect layer that enable the flow of electrical current between two or more points within an electro-optic or electronic device, and in particular between a die and an electrical path for testing the die.

As used herein, and unless otherwise specified, the term "continuous interconnect layer" refers to a single, uninterrupted layer of conductive material that provides an electrical connection between two or more points within an electro-optic or electronic device, and in particular between a die and an electrical path for testing the die. The continuous interconnect layer extends from a bottom of the cavity, runs along and in physical contact with said bottom and a sidewall of the cavity, across any topographical features of the device separating the start of the continuous interconnect layer and its end, where it electrically connects to the electrical path. This layer is continuous in the sense that it does not have breaks or gaps that would impede electrical conductivity. Examples of specific embodiments include a metal layer that spans across the surface of a substrate, connecting different components or regions, such as a die and an electrical path, without interruption. The continuous interconnect layer may be deposited by physical vapor deposition (PVD), chemical vapor deposition (CVD), electroplating, or electroless plating. Preferably, it is deposited by electroless plating.

In embodiment, the electro-optic or electronic device (102) may be a device for integrating at least one die. The die can, for instance, be a laser diode, such as a hybrid laser diode. The device may comprise an optical path (122) for interacting optically with the laser diode, when the laser diode is connected to said electrical connection (100).

As used herein, and unless otherwise specified, the term "electrically conductive protection layer" refers to a layer of material that is capable of conducting electricity and is applied to protect underlying layers or structures during processing steps, such as wet etching. This layer is preferably designed to be resistant to the chemicals used in the etching process, thereby preventing damage to the continuous interconnect layer or other critical features. Examples of specific embodiments include layers of nickel, cobalt, or other metals that exhibit selective etching properties when compared to materials like copper.

As used herein, and unless otherwise specified, the term "seed layer" refers to a thin layer, typically 20 to 200 nm thick, of material that is deposited onto a substrate to promote the adhesion and growth of subsequently deposited materials, such as metals in an electroplating process. The seed layer serves as a nucleation site for the growth of the continuous interconnect layer. Examples of specific embodiments include thin films of metals such as copper, nickel, or gold that are deposited by sputtering, evaporation, electroplating, or electroless plating.

As used herein, and unless otherwise specified, the term "barrier layer" refers to a layer of material that is designed to prevent the diffusion of atoms between adjacent layers within a device, thereby preserving the integrity and performance of the device. The barrier layer is typically resistant to intermixing with the materials it separates. Examples of specific embodiments include layers made of materials such as titanium tungsten (TiW), titanium nitride (TiN), or tantalum nitride (TaN), which are commonly used to prevent the diffusion of metals like copper into silicon or other materials.

As used herein, and unless otherwise specified, the term "connection bumps" refers to raised conductive features on a substrate or layer that are used to establish an electrical connection with corresponding features on another component, such as a die or another substrate. These bumps are typically used in flip-chip or similar packaging technologies to connect a die to a substrate or interposer. Examples of specific embodiments include bumps made of metals or metal alloys wherein the metals are selected from tin, silver, bismuth, indium, copper, cobalt, and gold, which can be formed by processes such as electroplating, stencil printing, or ball placement.

As used herein, and unless otherwise specified, the term "lift-off process" refers to a method of patterning thin films in which a patterned resist is used to define regions where material deposition is desired before said material is deposited over the patterned resist. After deposition, the resist is removed, "lifting off" the excess material and leaving behind the patterned thin film where openings were present in the resist. Examples of specific embodiments include the use of photoresist or other types of resist that can be patterned using photolithography, electron beam lithography, or other lithographic techniques, followed by deposition of materials such as metals.

As used herein, and unless otherwise specified, the term "carrier substrate" refers to a temporary support structure used to hold and transport multiple dies or components during the manufacturing process. The carrier substrate aligns the dies in a specific pattern corresponding to the pattern of cavities or connection sites on the device being assembled. Examples of specific embodiments include silicon wafers, glass plates, or other rigid or flexible materials that can be coated with an adhesive or other means of attachment to temporarily hold the dies in place during processing steps such as die placement and bonding.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

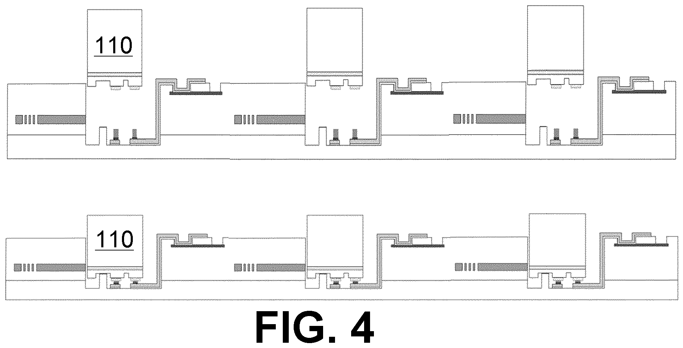

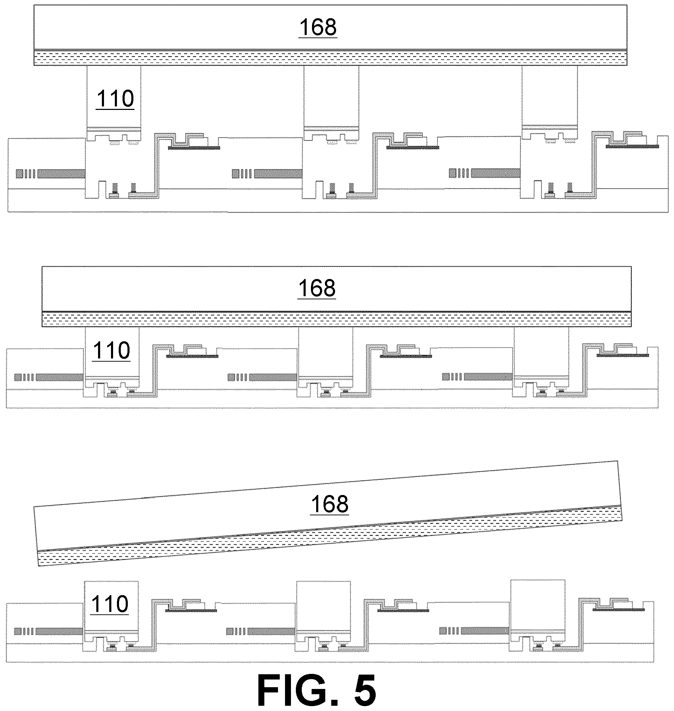

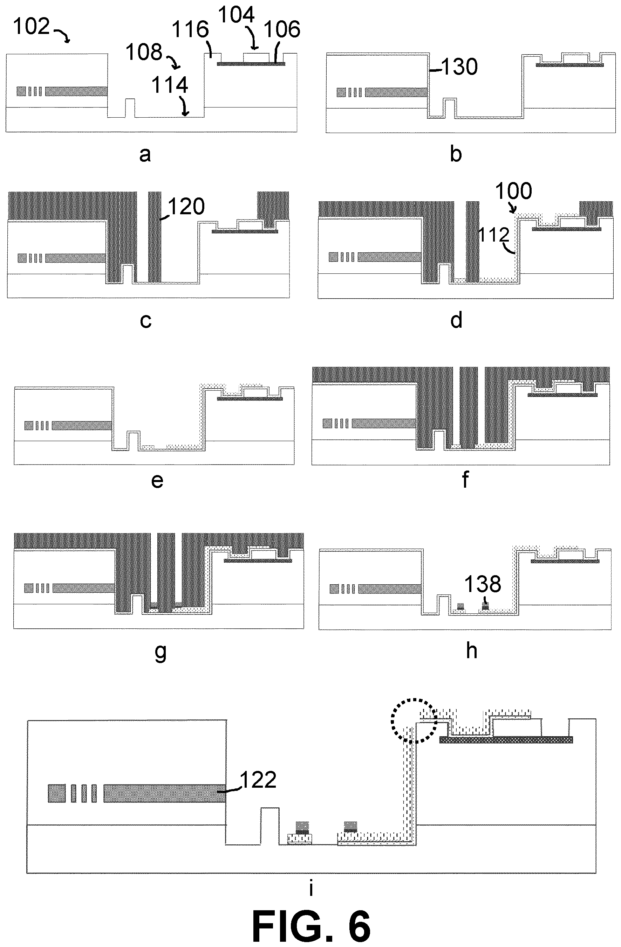

We now refer to Fig. 6, which shows a series of cross-sectional views illustrating various steps for forming a device (102) according to a first embodiment of the present invention. In this embodiment, no electrically conductive protection layer (118) is present on the electrical connection (112). Although this embodiment already has advantages compared to the prior art, as it provides an alternative to wire bonding and does not require a large cavity, it may be too fragile for some processes. In particular, the lack of protection layer is shown to have disadvantages, such as potential disconnection (see dashed circle in the last figure of Fig. 6) or damage to the electrical connection (112) during processing. In a first aspect, the present invention relates to a method for forming electrical connections (100) in an electro-optic or electronic device (102). As shown in Fig. 6a, the device includes a top surface (104) exposing an electrical path (106) and a cavity (108) in the top surface (104) for housing a die (110). The electrical connections (100) that will be established by the method are suitable for connecting the electrical path (106) and the die (110) (depicted in Fig. 4 and 5). The method involves forming a continuous interconnect layer (112) that extends from the bottom (114) of the cavity (108), across any topographical features (116), to the electrical path (106). This continuous interconnect layer (112) is crucial for ensuring reliable electrical connections between the die (110) and the device's circuitry (102).

To facilitate the formation of the continuous interconnect layer (112), the method may include depositing a seed layer (130) on the device (102) prior to forming the continuous interconnect layer (112). This is depicted in Fig. 6b. After forming the electrical connections (100), the seed layer (130) will be etched away, leaving it only under the electrical connections (100). Additionally, a barrier layer (not depicted) may be deposited before the seed layer (130) to prevent diffusion between the continuous interconnect layer (112) and underlying materials. Suitable materials for the barrier layer include TiW, TiN, or TaN.

In certain embodiments, the continuous interconnect layer (112) may include an electrically conductive protection layer (118) designed to prevent disconnection during a wet etch process. This protection layer (118) may comprise a metal with wet etching selectivity to copper, such as nickel or cobalt. The protection layer (118) may have a thickness ranging from 0.1 to 3.0 µm, with preferred ranges from 0.2 to 2.0 µm, more preferably from 0.3 to 1.0 µm, and yet more preferably from 0.3 to 0.7 µm. This ensures adequate protection while maintaining the overall conductivity of the interconnect layer (112).

Connection bumps (138) for the die (110) can be formed on the continuous interconnect layer (112) at the bottom (114) of the cavity (108). The formation of these connection bumps (138) may involve creating a patterned mask with openings that expose the continuous interconnect layer (112) only where the bumps (138) will be formed, followed by electroplating a metal through these openings. The material for the connection bumps (138) may include tin, silver, bismuth, indium, copper, cobalt, and gold.

The electrical path (106) is configured to enable electrical or electro-optical tests of the die (110) from the top surface (104), as depicted in Fig. 3. This configuration allows for testing without additional connections and contrasts with the prior art shown in Fig. 1, where wire connections are used, and Fig. 2, which shows direct testing in a large cavity. In embodiments, the electrical path (106) may comprise aluminum bond pads.

The method may employ a lift-off process for forming the continuous interconnect layer (112), where the material is deposited on a patterned resist and then the resist is removed to leave the interconnect layer (112) only in desired locations.

For devices with multiple cavities (108), the method includes providing a carrier substrate (168) removably attached to the same number of dies (110) arranged in a pattern matching the cavities (108). In embodiments, the number of cavities may exceed the number of dies attached to the substrate (168). However, there is at least a subset of the cavities that match the number and the pattern of the dies (110). The dies (110), attached to the carrier substrate (168), are physically contacted with the electronic device (102) so that each die (110) is housed in a cavity (108) and connects electrically with the continuous interconnect layer (112) present at the bottom (114) of the cavity (108). The carrier substrate (168) is then detached from the dies (110), as illustrated in the sequence of top views in Fig. 5, and the top view of the invention showing multiple cavities (108) prepared for die attachment in Fig. 4.

The second aspect of the invention relates to an opto-electronic or electronic device (102) comprising a top surface (104) exposing an electrical path (106), a cavity (108) in the top surface (104) for housing a die (110), and a continuous interconnect layer (112) extending from the bottom (114) of the cavity (108), across any topographical features (116), to the electrical path (106). The device (102) may include the same features as described in the method, such as the protection layer (118), barrier layer, connection bumps (138), and the configuration for testing.

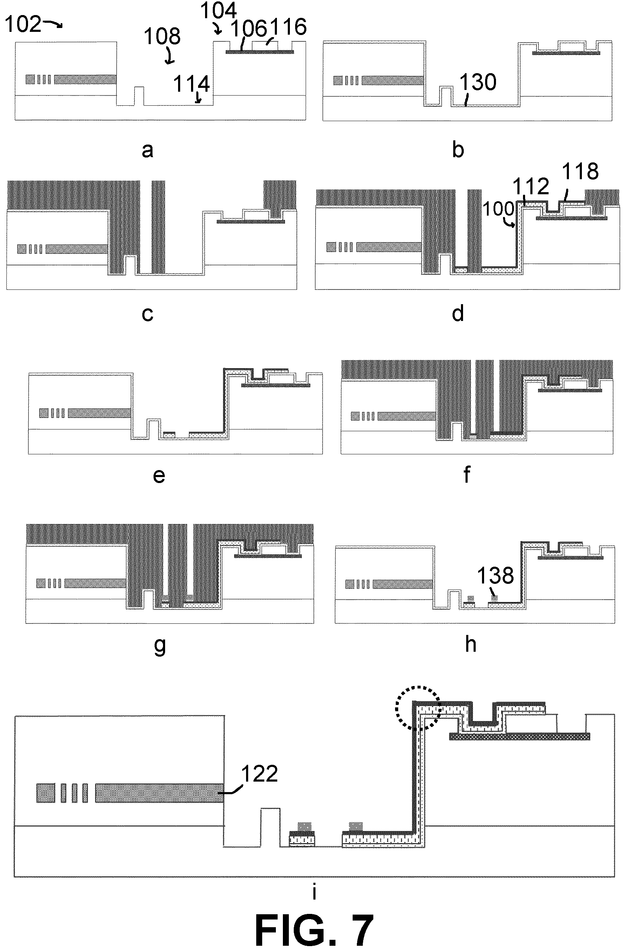

In summary, the invention provides a method and device (102) for forming electrical connections (100) that are robust, reliable, and suitable for efficient testing and integration into electronic and electro-optic devices. The inclusion of a protection layer (118), as shown in Fig. 7, offers significant advantages over the embodiment without such a layer, as highlighted in Fig. 6. The invention's design simplifies the testing process and improves the efficiency of die (110) placement and bonding in a patterned array.

### Example 1: Forming Electrical Connections in an Electro-Optic Device without a Protective Nickel Layer

An experiment was conducted to develop a method for forming electrical connections in an electro-optic device. The device comprised a top surface exposing an electrical path and a cavity in the top surface for housing a die. The aim was to create electrical connections suitable for connecting the electrical path and the die, enabling standard electrical and electro-optical testing of the bonded device from the top surface.

This experiment aimed to develop a method for forming reliable electrical connections in an electro-optic device, enabling standard electrical and electro-optical testing of the bonded die from the top surface. The method involves forming a continuous interconnect copper layer instead of using wire bonding.

Materials and Methods:
- Electro-optic device with a top surface exposing an electrical path and a cavity for housing a die
- Barrier material and deposition equipment
- Copper seed layer solution and equipment
- Copper plating solution and equipment
- Photoresist and lithography equipment
- Wet etching solutions for copper
- Bonding equipment and solder materials (e.g., tin, tin-silver, tin-bismuth, indium, indium-tin)

The procedure began with the preparation of the electro-optic device, which involved cleaning, applying a barrier layer, applying a seed layer (130) (see Fig. 6b), and applying a photoresist layer (120).

Subsequently, lithography was applied to define the specific regions designated for the plating of the continuous interconnect layer (112) (see Fig. 6c). This crucial layer, here composed of copper, was strategically designed to traverse from the bottom (114) of the cavity (108), across any present topographical features (116), and extend all the way to the electrical path (106) on the device's top surface (104). The deposition of the copper layer (see Fig. 6d) as the interconnect was achieved using specialized copper plating solutions and equipment. The photoresist (120) was then removed (see Fig. 6e).

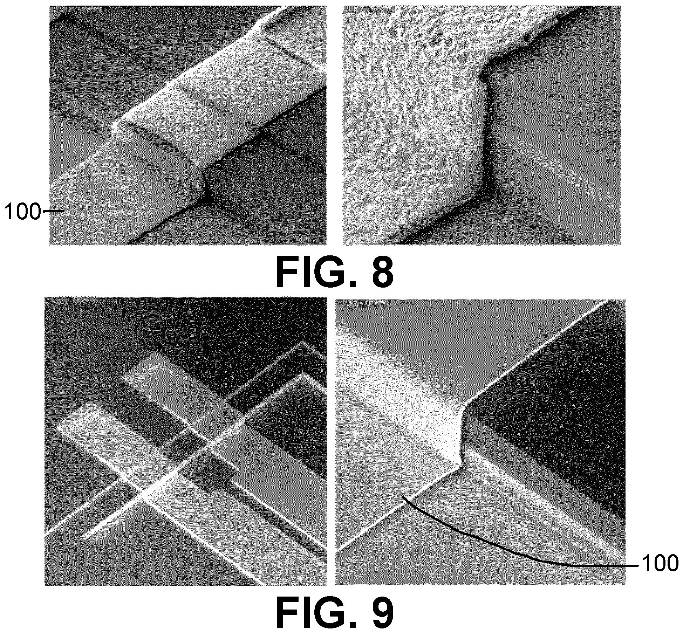

The next phase of the procedure involved another application of lithography (see Fig. 6f), this time with the objective of delineating the regions for the plating of connection bumps (138) at the cavity's bottom (114). These connection bumps were plated using suitable solder materials, ensuring a reliable point of contact for the die (110) within the cavity (see Fig. 6g). Once the connection bumps were plated, the photoresist was removed (see. Fig. 6g), and a series of cleaning steps were undertaken to maintain the integrity of the newly plated layers. The seed layer (130) was then removed by wet etching. A thinning of the copper layer was observed during the removal of the seed layer. In one run of the experiment, some parts of the coating were damaged, in particular at the corners (see Fig. 8).

By carefully controlling the exposure time to the etching solution, these drawbacks can be avoided.

The experimental findings highlighted several advantages of the developed method. Firstly, it eliminated the need for wire bonding or large cavities for probing inside the cavity to contact the bonded device. Secondly, it allowed for standard electrical and electro-optical measurements using aluminum bond pads on the top surface, without the need to contact the copper layer directly. Lastly, the use of a one-time barrier/seed layer for both the interconnect and bump plating steps streamlined the fabrication process.

### Example 2: Forming Electrical Connections in an Electro-Optic Device with a Protective Nickel Layer

This experiment, depicted in Fig. 7, aimed to develop a method for forming reliable electrical connections in an electro-optic device, enabling standard electrical and electro-optical testing of the bonded die from the top surface. The method involves plating a continuous interconnect layer with a protective nickel coating (118) (see Fig. 7d) to prevent damage sometimes observed in experiment 1 during the wet etch process, and improve reliability.

Materials and Methods:
- Electro-optic device with a top surface exposing an electrical path and a cavity for housing a die
- Barrier material and deposition equipment
- Copper seed layer solution and equipment
- Copper plating solution and equipment
- Nickel plating solution and equipment
- Photoresist and lithography equipment
- Wet etching solutions for copper and nickel
- Bonding equipment and solder materials (e.g., tin, tin-silver, tin-bismuth, indium, indium-tin)

The procedure was the same as for example 1 except that, following the copper plating, a thin nickel layer, with a thickness of approximately 0.5 µm, was plated directly on top of the copper layer, without the removal of the photoresist layer that was previously applied. Nickel was chosen due to its good wet etching selectivity to copper. This plating process, facilitated by nickel plating solutions and equipment, aimed to introduce an electrically conductive protection layer (118) over the copper, which would serve as a safeguard during subsequent processes. With the nickel layer in place, the photoresist was then removed, and a wet etch process was initiated to selectively remove the copper seed layer. The results showed that the nickel layer effectively protected the copper during the wet etch process, preventing disconnection and ensuring a smooth copper surface (see circled area in Fig. 7i and see Fig. 9).

In conclusion, the experiment successfully demonstrated a novel method for forming reliable electrical connections in electro-optic devices. By plating a continuous interconnect layer with a protective nickel coating, the method overcame the limitations of previous approaches and enabled efficient testing of the bonded device from the top surface. The findings have significant implications for improving the manufacturing and testing processes of electro-optic devices, leading to enhanced reliability and performance.

### Example 3: Bonding a die in the device of Example 2

We now refer to Fig. 3 and 4. A die (110) was bonded to the connection bumps within the cavity illustrated in Fig. 7i. this was performed utilizing bonding equipment designed for such a task. This step enabled the securing of the die within the cavity, ensuring both proper alignment and a robust connection. To conclude the comprehensive procedure, electrical and electro-optical tests were conducted on the bonded die, leveraging the electrical path (106) on the top surface (104) to evaluate the effectiveness of the connections and the overall performance of the electro-optic device (102).

The experiment demonstrated that the nickel layer acted as a barrier between the copper and the bonded die. During bonding, molten tin from the solder may squeeze out and come into contact with the copper, leading to reliability issues. The presence of the nickel layer prevented direct contact between tin and copper, improving the processing and reliability performance of the device.

### Example 4: Wafer-Level Bonding of Dies in Patterned Cavities

We now refer to Fig. 5. This experiment intends to showcase a technique for wafer-level bonding of dies (110) within patterned cavities of an electronic device. The process involves a carrier substrate (168) with dies attached in a matching pattern to the device's cavities, ensuring electrical continuity between the dies and the interconnect layer within the cavities, followed by the detachment of the carrier substrate.

In this procedure, we begin by preparing an electronic device that features a top surface designed with a series of cavities, each serving as a precise placement point for dies. These cavities are not just structural elements but are integrated with a continuous interconnect layer that extends from the bottom of each cavity to the device's top surface, a configuration that can be achieved as illustrated in examples 1 or 2. To facilitate this intricate assembly, we utilize a carrier substrate, onto which the dies are meticulously arranged in a pattern that mirrors the cavity layout on the device.

The core of the process involves aligning the carrier substrate, with its precisely arranged dies, above the electronic device. Preferably, passive alignment structures are employed. This alignment ensures that each die, guided by the passive alignment structures, is perfectly positioned over its corresponding cavity. Following this precise alignment, the substrate is carefully lowered, allowing each die to make contact with and be housed within its designated cavity. This is where the bonding equipment comes into play, securing each die to the interconnect layer within its cavity, ensuring a robust and reliable connection.

Once the dies are securely bonded within the cavities, the next step involves the delicate removal of the carrier substrate. This step is executed with precision, ensuring that the now bonded dies remain intact within their cavities. Following this, a thorough cleaning process is conducted, accompanied by an inspection phase to ensure that each die is correctly aligned within its cavity and that the electrical connections are established as intended.

The outcome of this designed procedure is the successful wafer-level bonding of dies within the patterned cavities of the electronic device. This not only ensures that the dies are securely housed within their respective cavities but also guarantees that they are in contact with the interconnect layer, facilitating the necessary electrical connections. The ease with which the carrier substrate can be removed post-bonding is a testament to the efficiency of this method. Ultimately, this approach to the wafer-level integration of dies into electronic devices promises to significantly streamline the assembly process while enhancing the overall performance of the devices.

It is to be understood that although preferred embodiments, specific constructions and configurations, as well as materials, have been discussed herein for devices according to the present invention, various changes or modifications in form and detail may be made without departing from the scope of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method for forming electrical connections (100) in an electro-optic or electronic device (102) comprising a top surface (104) exposing an electrical path (106), and a cavity (108) in the top surface (104), said cavity (108) being for housing a die (110), said electrical connections (100) being suitable for connecting the electrical path (106) and the die (110), wherein forming the electrical connections (100) comprises forming a continuous interconnect layer (112) extending from a bottom (114) of the cavity (108), across any topographical features (116), to the electrical path (106).

2. The method according to claim 1, wherein the continuous interconnect layer (112) includes an electrically conductive protection layer (118) suitable to prevent disconnection in the continuous interconnect layer (112) during a wet etch process.

3. The method according to claim 2, wherein the continuous interconnect layer (112) is made of copper and the electrically conductive protection layer (118) comprises a metal with wet etching selectivity to copper.

4. The method according to claim 3, wherein the metal is selected from nickel and cobalt.

5. The method according to any one of claims 2 to 4, wherein the protection layer (118) has a thickness of from 0.1 to 3.0 µm,preferably from 0.2 to 2.0 µm, more preferably from 0.3 to 1.0 µm, yet more preferably from 0.3 to 0.7 µm.

6. The method according to any one of claims 1 to 5, further comprising the step of depositing a seed layer (130) on the device (102) prior to forming the continuous interconnect layer (112), and comprising the step of etching the seed layer (130) after the forming of the electrical connections (100) so as to leave the seed layer (130) under the electrical connections (100) but remove it everywhere else.

7. The method according to any one of claims 1 to 6, further comprising the step of forming connection bumps (138) for the die (110) on the continuous interconnect layer (112) on the bottom (114) of the cavity (108).

8. The method according to any one of claims 1 to 7, wherein the electrical path (106) is configured to enable electrical or electro-optical tests of the die (110).

9. The method according to any one of claims 1 to 8, wherein the top surface (104) comprises therein a number of cavities (108) for housing a die (110), said number of cavities (108) forming a pattern, wherein the method further comprises:
- providing a carrier substrate (168) removably attached to a same number of dies (110) arranged in this same pattern,
- physically contacting the dies (110), attached to the carrier substrate (168), with the electronic device (102) in such a way that each die (110) is housed in a cavity (108) and connects electrically with the continuous interconnect layer (112) present at the bottom (114) of the cavity (108), and
- detaching the carrier substrate (168) from the dies (110).

10. An electro-optic or electronic device (102) comprising: a top surface (104) exposing an electrical path (106), a cavity (108) in the top surface (104) for housing a die (110), and a continuous interconnect layer (112) extending from a bottom (114) of the cavity (108), across any topographical features (116), to the electrical path (106).

11. The device (102) according to claim 10, wherein the continuous interconnect layer (112) includes a protection layer (118) comprising a metal with wet etching selectivity to the material making the continuous interconnect layer.

12. The device (102) according to claim 11, wherein the continuous interconnect layer is made of copper and the metal is nickel or cobalt.

13. The device (102) according to any one of claims 10 to 12, wherein the protection layer (118) has a thickness of from 0.1 to 3.0 µm, preferably from 0.2 to 2.0 µm, more preferably from 0.3 to 1.0 µm, yet more preferably from 0.3 to 0.7 µm.

14. The device (102) according to any one of claims 10 to 13, further comprising connection bumps (138) for the die (110) on the continuous interconnect layer (112) on the bottom (114) of the cavity (108).

15. The device (102) according to any one of claims 10 to 14, wherein the electrical path (106) is configured to enable electrical or electro-optical tests of the die (110). These electrical or electro-optical tests are typically tests of the embedded die (110) and are performed from the top surface (104).
